# EUROPÄISCHE PATENTSCHRIFT

(11) **EP 1 816 672 B1**
(45) Veröffentlichungstag und Bekanntmachung des Hinweises auf die Patenterteilung: **11.11.2009**
(21) Anmeldenummer: 07001508.6
(22) Anmeldetag: 24.01.2007
(51) Int. Cl.: H01L 21/20, H01L 21/265

(54) **Halbleiterschichtstruktur und Verfahren zur Herstellung einer Halbleiterschichtstruktur**
Semiconductor layer structure and method of fabricating it
Structure à couches semiconductrices et procédé de sa fabrication

(30) Priorität: 02.02.2006 DE 102006004870
(43) Veröffentlichungstag der Anmeldung: 08.08.2007
(73) Patentinhaber: Siltronic AG, 81737 München (DE)
(72) Erfinder: Murphy, Brian, 84347 Pfarrkirchen (DE); Häberlen, Maik, 86159 Augsburg (DE); Lindner, Jörg, Dr., 86399 Bobingen (DE); Stritzker, Bernd, Prof. Dr., 86438 Kissing (DE)
(74) Vertreter: Staudacher, Wolfgang

(56) Entgegenhaltungen:
- DE-A1- 10 318 283
- GB-A- 2 211 991
- US-A- 6 083 324
- US-B1- 6 562 703

## Beschreibung

Die Erfindung betrifft eine Halbleiterschichtstruktur und ein Verfahren zur Herstellung einer Halbleiterschichtstruktur.

Für die Realisierung moderner Bauelemente für Hochleistungssowie Optoelektronik werden im Stand der Technik üblicherweise Substrate verwendet, die sich nur sehr aufwändig und damit kostenintensiv herstellen lassen. Des Weiteren weisen diese Substrate oftmals eine hohe Defektdichte auf.

Eine Alternative, kostengünstige und qualitativ hochwertige Substrate zu erzeugen, besteht darin, eine dünne Schicht (wenige 10 nm) des gewünschten Substratmaterials auf einem qualitativ hochwertigen und kostengünstigen Substrat, wie beispielsweise auf einer Siliciumscheibe, abzuscheiden. Dabei erhält man gitterangepasste Substrate, welche eine defektarme epitaktische Abscheidung weiterer Schichten ermöglichen.

Allerdings werden dabei wesentliche physikalische Eigenschaften vom Substrat bestimmt, insbesondere der thermische Ausdehnungskoeffizient. Dies ist deshalb problematisch, da beispielsweise das Aufwachsen von III-V-Verbindungshalbleitern wie GaN mittels metallorganischer Gasphasenepitaxie (MOCVD) häufig bei verhältnismäßig hohen Temperaturen von über 1000°C erfolgt, um eine für die Bauelementherstellung ausreichende Qualität sicherzustellen. Kühlt eine bei solch hohen Temperaturen abgeschiedene Schicht auf einem Substrat ab, welches einen deutlich niedrigeren thermischen Ausdehnungskoeffizienten besitzt, so kommt es zunächst zu einer Zugverspannung der abgeschiedenen Schicht und im weiteren Verlauf oft zu einem Aufreißen der Schicht, was diese unbrauchbar macht.

In Journal of Crystal Growth 280, 346-351 (2005), N.H. Zhang et al. wird die Verwendung von Zwischenschichten abweichender Zusammensetzung und/oder Struktur bei der Abscheidung vorgeschlagen, welche die entstehenden Verspannungen kompensieren sollen.

Ein offensichtlicher Nachteil ist die komplizierte Prozessführung, da zur Erzeugung der Zwischenschichten in der Regel andere Prozessschritte und -parameter nötig sind als zur Abscheidung der gewünschten Schicht.

Prinzipiell stellen so genannte "compliant substrates" oder angepasste Substrate eine andere Möglichkeit dar. Hierunter versteht man Substrate, bei denen eine dünne Schicht des gewünschten Substratmaterials derart auf ein anderes Substrat aufgebracht wird, dass nur eine schwache mechanische Kopplung zwischen diesem Substrat und der aufgebrachten Schicht besteht.

Ein derartiges Verfahren ist beispielsweise in Journal of Electronic Materials 29(7), 897-900 (2000), Hobart et al. beschrieben. Dabei wird zunächst eine Si₁₋ₓGeₓ-Schicht auf einer SOI ("Silicon-on-insulator")-Scheibe abgeschieden, wobei die vergrabene Siliciumdioxidschicht zusätzlich mit Bor und Phosphor dotiert ist. Diese Bor-Phosphor-Silikatschicht hat die Eigenschaft, ab Temperaturen von etwa 800°C viskos fließen zu können, was eine Spannungsrelaxation jeglicher darauf abgeschiedener Schichten ermöglicht.

Dabei zeigt sich allerdings das Problem, dass abgeschiedene Schichten auf diesen Substraten ausbeulen. Der Grund hierfür liegt in der hohen Viskosität der Bor-Phosphor-Silikatschicht und der Notwendigkeit des thermischen Zusammenziehens der abgeschiedenen Schicht beim Abkühlen auf Raumtemperatur.
Da die Herstellung moderner Halbleiterbauelemente hohe Anforderungen an die Planarität der Schichten stellt, ist dies ein gravierender Nachteil. Ein solches Ausbeulen lässt sich in solchen Materialsystemen bisher nur - wie in obiger Veröffentlichung beschrieben - durch eine Strukturierung der Substrate erreichen, was vielfach unerwünscht ist.

Weitere Nachteile ergeben sich aus der Komplexität der Herstellung solcher Substrate. Meist werden SOI("Siliaon-on-Insulator")-Scheiben verwendet, die auf technisch aufwändigen Prozessen wie dem "Smart-cut"-Prozess oder Hochdosis-Sauerstoff-Ionenimplantation ("SIMOX"-Verfahren) basieren.

Andere Verfahren zur Herstellung derartiger virtueller Substrate, wie sie beispielsweise in EP 1437764 A1 und W02004/082001 A1 beschrieben sind, stellen gezielt einen Defektbereich im Substrat her, um relaxierte Schichten auf nicht gitterangepassten Substraten zu ermöglichen, insbesondere zum Erzeugen von verspannten Siliciumschichten ("strained silicon") auf relaxierten Si₁₋ₓGeₓ-Schichten, welche auf Silicium gewachsen wurden.

Es kommt hier ein Ionenimplantationsschritt zur Anwendung, welcher der Erzeugung eines Defektbereichs unterhalb der bereits vorher abgeschiedenen Schicht oder eines abgeschiedenen Schichtsystems dient. Dieser Defektbereich führt bei einer nachfolgenden thermischen Nachbehandlung zur Ausbildung von Versetzungen und Stapelfehlern im ursprünglichen Substrat, welche eine relaxierende Wirkung auf die abgeschiedene Schicht bzw. das Schichtsystem haben. Voraussetzung für diese Verfahren sind dünne defektarme Schichten auf dem Siliciumsubstrat, welche sich durch eine thermische Nachbehandlung nach dem Ionenimplantationsschritt relaxieren lassen.

Dabei besteht jedoch das Problem, dass die erzeugten Defektbereiche nur über kurze Zeiten stabil bleiben und bei längerer Prozessdauer ausheilen.

Dies hängt damit zusammen, dass Ostwald-Reifung stattfindet, also die Hohlräume ihre Größenverteilung durch Leerstellendiffusion vergröbern und sich zu wenigen, größeren Hohlräumen vereinigen. Dadurch wird die Dichte der erzeugten Hohlräume so klein, dass sich aus energetischen Gründen keine Versetzungen bzw. Stapelfehler mehr zwischen den Hohlräumen bilden. Dieses Problem tritt bei langen Prozesszeiten bei hohen Temperaturen wie beispielsweise bei der Abscheidung einer Schicht mittels MOCVD auf dieser Schichtstruktur auf. Da aufgrund der zu kleinen Dichte an Hohlräumen keine Relaxierung der Schichtstruktur beim Abkühlen mehr möglich ist, kommt es zum Aufreißen der abgeschiedenen Schicht.

Eine etwaige Erhöhung der Hohlraumdichte löst dieses Problem nur bedingt, da ab einer kritischen Dichte dieser Hohlräume - insbesondere bei angeschlossenen Hochtemperaturprozessen bei Temperaturen von größer oder gleich 1000°C - ein Abspalten der abgeschiedenen Schicht erfolgen kann.

Daher bestand die Aufgabe der vorliegenden Erfindung darin, Substrate zur spannungs- und rissfreien Abscheidung von Halbleitermaterialien sowie ein Verfahren zur Herstellung derartiger Substrate bereitzustellen.

Die Aufgabe der Erfindung wird gelöst durch ein Verfahren zur Herstellung einer Halbleiterschichtstruktur, umfassend folgende Schritte: a) Bereitstellen eines Substrats (1) aus Halbleitermaterial; b) Aufbringen einer Schicht (2) aus einem zweiten Halbleitermaterial auf dieses Substrat (1) zur Erzeugung einer Halbleiterschichtstruktur; c) Implantation von Gasionen einer oder mehrerer Atomsorten, ausgewählt aus einer Gruppe bestehend aus Wasserstoff und Edelgasen, in die Halbleiterschichtstruktur zur Erzeugung einer Hohlräume beinhaltenden Schicht (4) in der Halbleiterschichtstruktur; d) Aufbringen von wenigstens einer epitaktischen Schicht (6) auf die Halbleiterschichtstruktur, dadurch gekennzeichnet, dass es sich bei Substrat (1) um ein Siliciumsubstrat oder um ein Substrat, das eine Siliciumschicht beinhaltet, und bei Schicht (2) um Siliciumcarbid handelt, dass durch Implantation von Kohlenstoffionen in Substrat (1) eine vergrabene Siliciumcarbid-Schicht und durch deren anschließendes Freilegen Schicht (2) erzeugt wird und dass Fremdatome einer oder mehrerer Atomsorten, ausgewählt aus einer Gruppe Sauerstoff, Stickstoff und Kohlenstoff, mit einer Dosis von höchstens 5x10¹⁷ cm⁻² in die Halbleiterschichtstruktur implantiert werden, um die durch Gasimplantation erzeugten Hohlraume in Schicht (4) thermisch zu stabilisieren.

Beim in a) bereitgestellten Substrat handelt es sich vorzugsweise um eine Scheibe aus monokristallinem Silicium.

Des Weiteren ist auch die Verwendung von mittels Bonding-Verfahren hergestellten Halbleiterscheiben bevorzugt.

Ebenfalls bevorzugt ist die Verwendung einer SOI ("Silicon-on-insulator")-Scheibe als Substrat.

Das Substrat kann aber auch polykristallines Halbleitermaterial beinhalten.

Beim Substrat kann es sich des Weiteren auch um Schichtstrukturen handeln, die eine Siliciumschicht, eine Silicium-Germanium(SiGe)-Schicht oder eine Germaniumschicht beinhalten.

Allgemein sind alle Substrate geeignet, auf denen sich mono- oder polykristalline Schichten abscheiden lassen.

Bei der in Schritt b) aufzubringenden-Schicht aus einem zweiten Halbleitermaterial handelt es sich vorzugsweise um eine monokristalline Siliciumcarbidschicht.

Bevorzugt ist aber auch eine Silicium-Germanium-Schicht oder eine Schichtstruktur, die eine Silicium-Germanium-Schicht beinhaltet, als in Schritt b) aufzubringende Schicht.

Das Aufbringen der Schicht aus einem zweiten Halbleitermaterial zur Erzeugung einer Halbleiterschichtstruktur in Schritt b) des erfindungsgemäßen Verfahrens erfolgt vorzugsweise mittels chemischer Dampfphasenabscheidung ("Chemical Vapor Deposition", CVD), Molekularstrahlepitaxie ("Molecular Beam Epitaxy", MBE) oder durch Ionenstrahlsynthese ("Ion Beam Synthesis", IBS).

Je nach verwendeter Methode des Aufbringens der Schicht in Schritt b) sind Schichtdicken bei CVD 0,5 nm bis 100 µm, bei MBE 0,5 nm bis 5 µm und bei IBS 0,5 nm bis 1 µm bevorzugt.

Besonders bevorzugt beträgt die Schichtdicke der in b) aufgebrachten Schicht 1-500nm, unabhängig von der verwendeten Methode.

In Schritt c) des erfindungsgemäßen Verfahrens werden leichte Gasionen in die Halbleiterschichtstruktur implantiert.

Die Implantation der Gasionen kann in einem Tiefenbereich unterhalb einer Grenzfläche zwischen aufgebrachter Schicht und Substrat oder aber innerhalb der in b) aufgebrachten Schicht erfolgen.

Dabei wird eine Implantationsenergie im ersten Fall so gewählt, dass die Hohlräume knapp unterhalb einer Grenzfläche zwischen Substrat und aufgebrachter Schicht, also vorzugsweise im Bereich von 0-500 nm unterhalb jener Grenzfläche, entstehen.

Durch die Implantation von leichten Gasionen werden Hohlräume bzw. Blasen ("bubbles") in der Halbleiterschichtstruktur erzeugt.

Bei den implantierten Gasionen handelt es sich vorzugsweise um Wasserstoffionen.

Bevorzugt ist auch eine Implantation von Edelgasionen einer oder mehrerer Atomsorten, ausgewählt aus einer Gruppe Heliumionen, Neonionen und Argonionen.

Bei jener Implantation von Edelgasionen kann es sich auch um eine Implantation von Gemischen der genannten Atomsorten oder aber um eine Kombination aus separaten Implantationen der genannten Atomsorten handeln.

Beispielsweise kann also eine Heliumionenimplantation kombiniert werden mit einer Neonionenimplantation.

Bevorzugt ist aber auch eine Kombination aus einer Implantation von Wasserstoffionen und aus einer Implantation von Edelgasionen einer oder mehrerer Atomsorten, ausgewählt aus einer Gruppe Heliumionen, Neonionen und Argonionen.

Beispielsweise kann also eine Implantation von Wasserstoffionen kombiniert werden mit einer Implantation von Heliumionen.

Für eine beispielsweise 70 nm dicke SiC-Schicht auf einem Siliciumsubstrat wählt man beispielsweise eine Implantationsenergie von 22 keV für Heliumionen und eine Dosis von etwa 2×10¹⁶ cm⁻². Dies führt dann zu einem Defektbereich von etwa 0-70 nm unterhalb der Grenzfläche zwischen aufgebrachter Schicht und Substrat.

Niedrigere Implantationsenergien können gewählt werden, um den Defektbereich innerhalb der aufgebrachten Schicht zu erzeugen.

Bevorzugt liegen die Implantationsenergien, abhängig von Dicke und Art der abgeschiedenen Schicht, im Bereich von 1 keV-2 MeV.

Besonders bevorzugt liegen die Implantationsenergien im Bereich von 10-200 keV.

Dabei sind jedoch Implantationsenergien von 20-50 keV ganz besonders zu bevorzugen.

Über die Wahl der Implantationstemperatur lässt sich der Zeitpunkt der Entstehung der Hohlräume steuern:

Wählt man niedrige Implantationstemperaturen und hohe Dosen werden bereits unmittelbar nach der Implantation Hohlräume einer gewissen Größe erzeugt.

Es hat sich aber als vorteilhaft erwiesen, höhere Implantationstemperaturen von etwa 400 °C zu wählen, um zunächst nur Keime für Hohlräume zu erzeugen, welche nach geeigneter Stabilisierung derselben durch Fremdatome selbst bei nachfolgenden langen Hochtemperaturprozessen bei Temperaturen von 900-1250 °C sowie Behandlungsdauern von 2 Stunden oder länger in einer schmalen Hohlraumverteilung mit mittleren Hohlraumdurchmessern von etwa 10 nm resultieren.

Insbesondere kann ein späteres Abspalten der Schicht in einem Hochtemperaturprozess bis zu einer Temperatur von 1250 °C vermieden werden.

Die Wahl der zu implantierenden Dosen der Wasserstoff- oder Edelgasionen ist abhängig von Art und,Dicke der aufgebrachten Schicht sowie von der Implantationsenergie.

Vorzugsweise liegen die zu implantierenden Dosen der Wasserstoff- und/oder Edelgasionen im Bereich von 1×10¹³ - 1×10¹⁷ cm⁻².

Besonders bevorzugt sind Dosen im Bereich von 1×10¹⁵ cm⁻² - 5×10¹⁶ cm⁻².

Dem Fachmann ist bekannt, dass die resultierenden Konzentrationen an Fremdatomen von der implantierten Dosis und von der thermischen Ausdiffusion abhängig sind. Die benötigten Dosen werden daher vorzugsweise experimentell bestimmt.

Eine Verkippung der Halbleiterschichtstruktur gegenüber dem Ionenstrahl während der Implantation ist ebenfalls bevorzugt.

Vorzugsweise wird die Halbleiterschichtstruktur um einen Winkel von 0-60° gegen den Ionenstrahl verkippt.

Besonders zu bevorzugen sind Winkel von 0-30°, wobei Winkel von 0-15°_ganz besonders zu bevorzugen sind.

In Schritt d) des erfindungsgemäßen Verfahrens werden die Hohlräume in der Halbleiterschichtstruktur durch Fremdatome einer oder mehrerer Atomsorten, ausgewählt aus einer Gruppe Sauerstoff, Stickstoff und Kohlenstoff, stabilisiert.

Dies erfolgt für den Fall, dass im Substrat und/oder in der aufgebrachten Schicht bereits Fremdatome jener Atomsorten wenigstens im Bereich Hohlräume beinhaltenden Schicht vorhanden sind, vorzugsweise durch eine thermische Behandlung der erzeugten Halbleiterschichtstruktur bei wenigstens 600°C.

Die Fremdatome können dabei gelöst, in Form von Verbindungen mit dem Substratmaterial oder als Präzipitate vorhanden sein.

Eine separate thermische Behandlung ist jedoch nicht erforderlich und auch nicht bevorzugt, wenn das Aufbringen der wenigstens einen epitaktischen Schicht gemäß Schritt e) bei einer Temperatur von wenigstens 600°C erfolgt.

Unterhalb dieser Temperatur werden keine ausreichenden Dichten an flächenhaften Defekten erreicht, wie sie für eine Relaxation der abgeschiedenen Schicht benötigt werden.

Eine thermische Behandlung der Halbleiterschichtstruktur bei sehr hohen Temperaturen von 1300 °C oder höher ist prinzipiell möglich. Allerdings muss hier die Dynamik der Ostwaldreifung beachtet werden, welche bei derartigen Temperaturen auch bei Fremdatom-stabilisierten Hohlräumen zu unerwünschten Effekten führen kann. Vor allem gilt es ein Abplatzen der aufgebrachten Schicht, sowie eine zu starke Dichteabnahme der Hohlräume infolge Vergröberung zu vermeiden. Daher erfolgen die thermische Behandlung der Halbleiterschichtstruktur bzw. die Abscheidung von epitaktischen Schichten auf der Halbleiterschichtstruktur vorzugsweise bei Temperaturen von 600-1250 °C.

Falls im Substrat bzw. wenigstens im Bereich der erzeugten Hohlräume keine Fremdatome einer oder mehrerer Atomsorten, die vorzugsweise ausgewählt sind aus einer Gruppe Stickstoff, Sauerstoff und Kohlenstoff, in ausreichender Konzentration vorhanden sind, erfolgt in Schritt d) vorzugsweise eine Implantation von Ionen dieser Atomsorten in die Halbleiterschichtstruktur.

Dabei wird die Implantation vorzugsweise so gewählt, dass das Konzentrationsmaximum der Fremdatome und das Konzentrationsmaximum der implantierten Gasionen zusammenfallen oder zumindest in einem ähnlichen Tiefenbereich liegen.

Daher werden vorzugsweise Implantationsenergien von 10-200 keV gewählt.

Auf die Halbleiterschichtstruktur wird schließlich gemäß Schritt e) wenigstens eine epitaktische Schicht aufgebracht.

Jene wenigstens eine epitaktische Schicht ist vorzugsweise eine Schicht aus monokristallinem Silicium.

Vorzugsweise beinhaltet die wenigstens eine epitaktische Schicht einen Nitridverbindungshalbleiter.

Vorzugsweise beinhaltet diese wenigstens eine epitaktische Schicht Halbleitermaterial mit einem gegenüber dem Halbleitermaterial des Substrats deutlich verschiedenen, nämlich höheren thermischen Ausdehnungskoeffizienten.

Beispielsweise haben alle Verbindungshalbleiter einen gegenüber Silicium stark verschiedenen, nämlich einen größeren thermischen Ausdehnungskoeffizienten, vgl. Tabelle 1.

Es handelt sich bei den abgeschiedenen Schichten typischerweise um II-VI- und III-V-Verbindungshalbleiter. Im Besonderen sind dies Schichten aus: AlₓGa₁₋ₓN, AlₓGa_{y}In_{1-x-y}N, AlₓGa_{y}In_{1-x-y}P,-AlₓGa₁₋ₓSb, AlₓGaylnl₋ₓ₋yNₐSb₁-ₐ, AlₓGa_{y}In_{1-x-y}NₐP_{b}Sb_{1-a-b}, GaAs, ZnO, CdTe, CdS, CdSe und CdSₓSe₁₋ₓ.

Insbesondere sind auch Schichtstapel als Kombination obiger Verbindungshalbleiter denkbar und bevorzugt.

**Tabelle 1: Thermische Ausdehnungskoeffizienten für ausgewählte Halbleitermaterialien.**

| **Material** | **lin. therm. Ausdehnungskoeff. (kub.) [10⁻⁶/K]** | **lin. therm. Ausdehnungskoeff. (hex., αₐ) [10⁻⁶/K]** | **lin. therm. Ausdehnungskoeff. (hex., α_{c}) [10⁻⁶/K]** |
|---|---|---|---|
| Si | 2,6 | | |
| GaN | | 5,59 | 3,17 |
| 3C-SiC | 3,8 | | |
| 6H-SiC | | 4,3 | 4,7 |
| Zn0 | | 6,51 | 3,02 |
| AlN | | 4,15 | 5,27 |

Dabei können diese Schichten natürlich entsprechend ihrem Anwendungszweck mit Fremdatomen beliebiger Art dotiert sein.

Je nach gewünschter Orientierung bzw. Kristallstruktur können im Falle der Verwendung von Silicium als Substrat (100)-, (110)-, (111)- oder auch fehlorientierte Halbleiterscheiben verwendet werden.

Falls es sich bei der Halbleiterschichtstruktur um eine Siliciumcarbidschicht auf einer Siliciumscheibe handelt, sind die Abscheidung von Nitridverbindungshalbleitern und damit die Herstellung von Ausgangsmaterialien für Anwendungen in der Optoelektronik bevorzugt.

Dabei ist die Siliciumcarbidschicht vorzugsweise zwischen 1 nm und 500 nm dick.

Besonders bevorzugt liegt die Schichtdicke im Bereich 30 nm bis 150 nm, wobei Schichtdicken zwischen 50 nm und 100 nm ganz besonders zu bevorzugen sind.

Die Dicke der abgeschiedenen Nitridschicht liegt vorzugsweise - entsprechend der späteren Anwendung - im Bereich von 100 nm bis 100 µm, wobei Schichtdicken im Bereich 200 nm bis 20 µm besonders bevorzugt sind und Schichten mit Dicken zwischen 500 nm und 5 µm ganz besonders zu bevorzugen sind.

Handelt es sich um eine Schichtstruktur aus GaN/AlN auf einer Siliciumcarbidschicht auf Silicium, so lassen sich Fadenversetzungsdichten von kleiner oder gleich 10¹⁰ cm⁻², bevorzugt im Bereich von 10⁶- 10¹⁰ cm⁻² erzielen.

Die Aufgabe der Erfindung wird auch gelöst durch eine Halbleiterschichtstruktur, umfassend ein Substrat (1) aus Silicium oder ein eine Siliciumschicht beinhaltendes Substrat (1), auf dem sich eine Schicht (2) aus Siliciumcarbid befindet, des Weiteren einen mit Fremdatomen einer oder mehrerer Atomsorten, ausgewählt aus einer Gruppe bestehend aus Sauerstoff, Stickstoff und Kohlenstoff, angereicherten Bereich (3), der sich entweder in Schicht (2) oder in einer bestimmten Tiefe unterhalb der Grenzfläche zwischen Schicht (2) und Substrat (1) befindet und Siliciumcarbidpräzipitate beinhaltet, außerdem eine Schicht (4) innerhalb des mit Fremdatomen angereicherten Bereichs (3), die Hohlräume in Form von Wasserstoff- und/oder Edelgasbläschen beinhaltet, des Weiteren wenigstens eine epitaktische Schicht (6), die auf Schicht (2) aufgebracht ist, sowie einen Defektbereich (5) aus Versetzungen und Stapelfehlern innerhalb der Hohlräume beinhaltenden Schicht (4), wobei die wenigstens eine epitaktische Schicht (6) weitgehend rissfrei ist, und eine residuale Verspannung der wenigstens einen epitaktischen Schicht (6) kleiner oder gleich 1 GPa beträgt.

Dabei ist im Rahmen der Erfindung unter Rissen ein spannungsinduziertes Aufreißen der wenigstens einen epitaktischen Schicht zu verstehen, wobei dieses Aufreißen bis in das Substrat gehen kann.

Derartige Risse können mittels optischer Mikroskopie, Rasterelektronenmikroskopie, Rasterkraftmikroskopie oder Röntgentopographie festgestellt werden.

Vorzugweise beträgt die residuale Verspannung der wenigsten einen epitaktischen Schicht kleiner oder gleich 370 MPa.

Die Rauhigkeit der wenigstens einen epitaktischen Schicht beträgt vorzugsweise kleiner oder gleich 7,0 nm RMS, besonders bevorzugt 0,5-2,0 nm RMS.

Beim Substrat aus Halbleitermaterial handelt es sich vorzugsweise um eine Scheibe aus monokristallinem Silicium.

Bevorzugt ist auch das Bereitstellen einer SOI-Scheibe als Substrat.

Außerdem ist auch eine mittels eines Bonding-Verfahrens hergestellte Halbleiterscheibe als Substrat bevorzugt.

Das Substrat kann jedoch auch polykristallines Halbleitermaterial beinhalten.

Es kann sich aber auch um ein Substrat handeln, dass eine Silicium-, eine Silicium-Germanium- oder eine Germanium-Schicht beinhaltet.

Der mit Fremdatomen angereicherte Bereich ist vorzugsweise mit Fremdatomen einer oder mehrerer Atomsorten, ausgewählt aus einer Gruppe Sauerstoff, Stickstoff oder Kohlenstoff, angereichert.

Die Hohlräume beinhaltende Schicht innerhalb des mit Fremdatomen angereicherten Bereichs ist vorzugsweise durch Implantation von leichten Gasionen erzeugt wurden.

Bei den implantierten Gasionen handelt es sich vorzugsweise um Wasserstoffionen.

Bevorzugt handelt es sich bei den implantierten Gasionen um Edelgasionen einer oder mehrerer Atomsorten, ausgewählt aus einer Gruppe Heliumionen, Neonionen und Argonionen.

Des Weiteren ist auch bevorzugt, dass die Hohlräume durch Kombinationen von Implantationen von Edelgasionen einer oder mehrerer Atomsorten, ausgewählt aus einer Gruppe Heliumionen, Neonionen und Argonionen, erzeugt wurden.

Beispielsweise können die Hohlräume durch eine Implantation von Heliumionen und eine zusätzliche Implantation von Neon- oder Argonionen erzeugt worden sein. Auch entsprechende Gasgemische sind zur Erzeugung der Hohlräume denkbar.

Bevorzugt ist aber auch die Erzeugung dieser Hohlräume durch eine Kombination aus einer Implantation von Wasserstoffionen und aus einer Implantation von Edelgasionen einer oder mehrerer Atomsorten, ausgewählt aus einer Gruppe Heliumionen, Neonionen und Argonionen.

Als Beispiel sei hier eine Kombination aus Wasserstoff- und Heliumimplantierten Hohlräumen genannt.

Bei der auf dem Substrat befindlichen Schicht aus einem zweiten Halbleitermaterial handelt es sich vorzugsweise um eine monokristalline Siliciumcarbidschicht, besonders bevorzugt um ionenstrahlsynthetisiertes Siliciumcarbid auf einem Substrat aus monokristallinem Silicium.

Die relative Dehnung der Gitterkonstante von Siliciumcarbid beträgt in dieser Siliciumcarbidschicht weniger als 0,2%, was einer residualen Verspannung der Siliciumcarbidschicht von weniger als 1 GPa entspricht.

Die residuale Verspannung der wenigstens einen, auf der Siliciumcarbidschicht abgeschiedenen epitaktischen Schicht beträgt dann kleiner oder gleich 370 MPa.

Die Erfindung betrifft.also auch eine Halbleiterschichtstruktur, umfassend eine Schicht aus ionenstrahlsynthetisiertem Siliciumcarbid auf einem Substrat aus monokristallinem Silicium, wobei eine mittels hochauflösender Röntgenbeugung gemessene relative Ausdehnung der Gitterkonstante von Siliciumcarbid in dieser Schicht kleiner oder gleich 0,2% beträgt.

Die Gitterkonstante und deren relative Dehnung werden dabei beispielsweise mittels hoch auflösender Röntgenbeugung (HR-XRD) gemessen. Die gemessene Verschiebung gegenüber dem unverspannten Wert für die Gitterkonstante ergibt durch Umrechnung mittels der elastischen Eigenschaften, also mittels der elastischen Konstanten des Halbleitermaterials, den angegebenen Wert für die residuale Verspannung des Materials.

Bei der auf dem Substrat befindlichen Schicht aus einem zweiten Halbleitermaterial kann es sich auch um eine Schichtstruktur handeln, die aus einer monokristallinen Siliciumcarbidschicht auf polykristallinem Siliciumcarbid besteht.

Die wenigstens eine epitaktische Schicht auf der Halbleiterschichtstruktur beinhaltet vorzugsweise Halbleitermaterial mit einem gegenüber dem Halbleitermaterial des Substrats deutlich verschiedenen, nämlich höheren thermischen Ausdehnungskoeffizienten.

Vorzugsweise beinhaltet eine erste epitaktische Schicht einen Nitridverbindungshalbleiter. Vorzugsweise ist auf die Halbleiterschichtstruktur eine zweite epitaktische Schicht, die einen Nitridverbindungshalbleiter beinhaltet, aufgebracht. Die erste epitaktische Schicht beinhaltet vorzugsweise Aluminiumnitrid, die zweite epitaktische Schicht vorzugsweise Galliumnitrid.

Auf derartigen Halbleiterschichtstrukturen lassen sich optoelektronische Halbleiterbauelemente herstellen, welche nach Aktivierung Licht einer Energie von 0,1-7,0 eV emittieren.

Bei der auf dem Substrat befindlichen Schicht aus einem zweiten Halbleitermaterial ist auch eine SiGe-Schicht oder eine Schichtstruktur, deren oberste Schicht eine SiGe-Schicht ist, bevorzugt. Bei der epitaktischen Schicht handelt es sich in diesem Fall vorzugsweise um eine epitaktische Siliciumschicht, die auf jener SiGe-Schicht oder jener SiGe beinhaltenden Schichtstruktur aufgebracht ist.

Das erfindungsgemäße Verfahren und die erfindungsgemäße Halbleiterschichtstruktur sollen im Folgenden an besonders bevorzugten Ausführungsformen und für den Fall einer Halbleiterschichtstruktur, welche 3C-SiC auf Silicium beinhaltet, erläutert werden.

Es hat sich gezeigt, dass das erfindungsgemäße Verfahren besonders gut geeignet ist, eine verhältnismäßig dicke rissfreie Schicht, die zwischen 100 nm und 100µm dick, also beispielsweise 2,5 µm dick ist, die beispielsweise AlₓGa₁₋ₓN mit einem hohen thermischem Ausdehnungskoeffizienten beinhaltet, auf einer ionenstrahlsynthetisierten Halbleiterschichtstruktur, wie beispielsweise 3C-Siliciumcarbid auf Silicium, welche einen niedrigen thermischem Ausdehnungskoeffizienten aufweist, bei für metallorganische Gasphasenabscheidung (MOCVD) typischen, hohen Temperaturen von etwa 1100°C abzuscheiden.

Denn im Rahmen der Erfindung wurde festgestellt, dass die Einführung einer Defektstruktur in eine ionenstrahlsynthetisierte Halbleiterschichtstruktur vorteilhaft für die spätere riss- und spannungsfreie Abscheidung von Nitridverbindungshalbleitern ist.

Dazu wird vorzugsweise in einer 3C-SiC-Si-Halbleiterschichtstruktur durch Implantation leichter Gasionen, wie Wasserstoff, Helium, Neon oder Argon (oder auch Kombinationen davon), ein defektreicher Bereich knapp unterhalb, also vorzugsweise in einem Tiefenintervall von 0-500 nm unterhalb der Grenzfläche zwischen 3C-SiC und Silicium, erzeugt, welcher aus gasgefüllten Blasen bzw. Hohlräumen und gegebenenfalls zusätzlich aus einem Versetzungsnetzwerk und Stapelfehlern zwischen diesen Blasen bzw. Hohlräumen besteht. Die oben genannte Implantation kann ebenfalls nur in die 3C-SiC-Schicht erfolgen, was in einer von Defekten begleiteten Hohlraumstruktur oberhalb der Grenzfläche resultiert.

Diese Defektstruktur bewirkt beim späteren Aufwachsen eines Materials mit höherem thermischen Ausdehnungskoeffizienten bei hohen Temperaturen - also mindestens 600°C bis maximal knapp unterhalb des Schmelzpunkts von Silicium -, dass während des Abkühlvorgangs der obere Teil des Siliciumsubstrats thermische Spannungen plastisch relaxieren kann, in dem zwischen den Blasen bzw. Hohlräumen Versetzungen und Stapelfehler ausgebildet werden und/oder Silizium in diese Hohlräume inkorporiert wird.

Vor allem die Ausbildung von Versetzungen und Stapelfehlern, sowie die Inkorporation von Silicium in Hohlräume würde dazu führen, dass eine tensile Verspannung der auf die Schichtstruktur aufgebrachten Schicht bzw. Schichten beim Abkühlvorgang dynamisch abgebaut und vom oberflächennahen Bereich der Schichtstruktur aufgefangen würde.

Ein bereits im Stand der Technik bekanntes Problem stellen die bei der MOCVD-Abscheidung von III-V-Halbleiterschichten vorliegenden typischen Wachstumsraten (typischerweise 1 µm/h) und damit langen Prozesszeiten bei hohen Temperaturen dar, da durch Ionenimplantation hergestellte Hohlräume dem Phänomen der Ostwald-Reifung unterliegen und sich kleine Hohlräume durch Leerstellendiffusion vergröbern. Dies führt zu einer zeitlichen Abnahme der Dichte dieser Hohlräume. Damit wird die Ausbildung von Versetzungen energetisch ungünstiger, da die Energie einer Versetzung mit ihrer linearen Ausdehnung steigt, was dazu führen kann, dass keine Versetzungen mehr ausgebildet werden und kein relaxierender Effekt mehr vorliegt.

Aus Nuclear Instruments and Methods B 175-177 (2001), 132-139, Donnelly et al, war bereits bekannt, dass sich beispielsweise durch Implantation von Kohlenstoff oder Sauerstoff in einen Bereich, in dem nachfolgend ein Defektbereich aus Bläschen beispielsweise mittels Helium-Implantation gefolgt von einer thermischen Behandlung erzeugt wird, das Phänomen der Ostwald-Reifung bzw. das Zusammenwachsen von kleineren Bläschen zu größeren Hohlräumen abschwächen lässt. Dies wurde insbesondere zur Stabilisierung der Hohlräume angestrebt, um Gettering von metallischen Verunreinigungen zu optimieren.

Im Rahmen der hier vorgelegten Erfindung wurde festgestellt, dass sich durch Ionenimplantation erzeugte Hohlräume in Silicium durch Implantation von Sauerstoff-, Stickstoff- oder Kohlenstoffionen oder Kombination von Implantationen dieser Ionensorten selbst bei hohen Temperaturen stabilisieren lassen, insbesondere weit über den von Donnelly betrachteten Zeit- und Temperaturbereich von 900°C und 30 Minuten hinaus.

Dabei können die Fremdatome durch Ionenimplantation auch nach der Erzeugung der Helium-Blasen in den betreffenden Tiefenbereich eingebracht werden.

Insbesondere lassen sich dadurch höhere Flächendichten der Hohlräume und somit höhere Dichten an relaxierenden Defektstrukturen realisieren, womit eine weitgehende Relaxation der abgeschiedenen Schichten erreicht werden kann. Erst dies ermöglicht eine Abscheidung von epitaktischen Schichten von Halbleitern mit einem gegenüber Silicium stark unterschiedlichen thermischen Ausdehungskoeffizienten.

Insbesondere können durch eine hohe Dichte von Hohlräumen die Distanzen zwischen denselben soweit reduziert werden, dass Defektstrukturen aus Versetzungen und Stapelfehlern energetisch so günstig werden, das diese bis zu tiefen Temperaturen bei etwa 600 °C zwischen diesen Hohlräumen ausgebildet werden können. Somit ist eine dynamische Relaxation einer epitaktischen Schicht auf der Halbleiterschichtstruktur möglich.

Wären keine Hohlräume vorhanden, bzw. wäre die Dichte an Hohlräumen gering, wäre auch die Distanz zwischen zwei Hohlräumen groß und somit wären Versetzungen und Stapelfehler energetisch ungünstig, da die Energie dieser Defekte abhängig von ihrer Ausdehnung ist. Es ist also anzustreben, eine hohe Dichte stabiler Hohlräume zu erzeugen.

Insbesondere müssen die Hohlräume auch thermisch stabil sein, dürfen also nicht zusammenwachsen und eine thermische Trennschicht bilden im Bereich einer Temperatur von 25-1250 °C.

Die Hohlräume müssen des Weiteren auch mechanisch stabil sein, um weitere bauelementerelevante Prozessschritte zu erlauben. Dem Fachmann ist bekannt, dass die thermische Stabilität der Hohlräume durch höhere bzw. niedrigere Sauerstoffimplantationsdosis weiter erhöht bzw. erniedrigt werden kann.

Insbesondere sei darauf hingewiesen, dass typische Abscheidezeiten und Temperaturen bei der MOCVD höher liegen als entsprechende Parameter für Gettering von Verunreinigungen.

In Experimenten wurde festgestellt, dass eine Post-Implantation der Fremdatome zur Stabilisierung der Hohlräume einer Pre-Implantation vorzuziehen ist. Eine Pre-Implantation führt bei sonst gleichen Parametern im Vergleich zu einer Post-Implantation zum Blistern, also zur Ablösung von Teilen der Schichtstruktur vom Substrat. Es lassen sich also höhere Hohlraumdichten - und somit auch höhere Dichten an relaxierenden Defekten durch eine Post-Implantation der Fremdatome erreichen.

Die Erfinder haben des Weiteren erkannt, dass der stabilisierende Effekt dabei zum einen auf die Bildung von starken Si-O- oder Si-C-Bindungen zurückzuführen ist, die für eine Veränderung eines ausgedehnten Hohlraumes erst aufgebrochen werden müssen. Zum anderen wird durch eine Fremdatomimplanation die Diffusivität von Helium und Leerstellenkomplexen abgesenkt, was eine Ostwald-Reifung von Heliumblasen bzw. Hohlräumen stark einschränkt.

Dadurch bleibt die Dichte an Hohlräumen selbst für lange Zeiten bei hohen Temperaturen - also für mehrere Stunden und bei Temperaturen von 1050 °C und höher) - groß, und die Bildung von Versetzungen für eine gewünschte plastische Relaxation bleibt energetisch günstig.

Somit ergibt die Kombination aus der Erzeugung einer ionenstrahlsynthetisierten Schichtstruktur mit der Bereitstellung eines hochtemperaturstabilen Defektbereichs innerhalb des Ausgangssubstrates ein ideales Substrat für die Abscheidung von Halbleiterschichten bzw. -strukturen mit stark unterschiedlichen thermischen Ausdehungskoeffizienten.

Eine ionenstrahlsynthetisierte Halbleiterschichtstruktur lässt sich herstellen, indem Ionen in eine bestimmte Tiefe eines Substrats implantiert werden, dieses dann thermisch behandelt wird, wodurch sich im Substrat eine vergrabene monokristalline Schicht sowie oberhalb und unterhalb der monokristallinen Schicht Übergangsregionen ausbilden, nachfolgend die obere Substratschicht sowie die über der monokristallinen Schicht liegende Übergangsregion abgetragen werden, wodurch die monokristalline Schicht freigelegt wird.

Durch Ionenimplantation der gewünschten Ionensorte bei entsprechenden Bedingungen werden zunächst kleine epitaktische Kristallite der beabsichtigten Verbindung aus Substratatomen und implantierten Ionen erzeugt. In einem thermischen Behandlungsschritt wachsen diese Kristallite zusammen und bilden eine zusammenhängende monokristalline Schicht.

Als Beispiel sei hier die Herstellung einer vergrabenen 3C-SiC-Schicht in Silicium durch Implantation von Kohlenstoffionen in ein Siliciumsubstrat genannt.

Um die erzeugte Verbindungshalbleiterschicht an die Oberfläche zu bringen, werden in einem folgenden Schritt die Substratdeckschicht sowie die über der monokristallinen Schicht liegende Übergangsregion abgetragen. Dazu wird vorzugsweise eine chemische Ätzbehandlung durchgeführt. Alternativ kann diese Schicht jedoch auch mittels Oxidation und nachfolgender chemischer Entfernung dieses gebildeten Oxids oder durch Polieren oder auch durch reaktives Ionenätzen bzw. Plasmaätzen freigelegt werden.

Optional kann dann anschließend die freigelegte Oberfläche der monokristallinen Schicht chemo-mechanisch oder durch einen thermischen Behandlungsschritt bei hohen Temperaturen geglättet werden, typischerweise auf eine Oberflächenrauhigkeit von 5 nm RMS oder weniger.

Bevorzugt sind RMS-Rauigkeitswerte von 1 nm RMS oder weniger, besonders bevorzugt 0,5 nm RMS oder weniger.

Eine weitere Möglichkeit zur Glättung der Oberfläche bietet der Einsatz von Ionenstrahlen oder Cluster-Ionenstrahlen.

Um in dieser ionenstrahlsynthetisierten Halbleiterschichtstruktur nun eine thermisch stabile Defektstruktur aus Versetzungen und Stapelfehlern zu erzeugen, werden zunächst Kohlenstoff-, Sauerstoff-, oder Stickstoffionen oder Kombinationen davon mit einer Dosis von höchstens 5×10¹⁷ cm⁻² in die erzeugte Halbleiterschichtstruktur implantiert.

Dabei wird die Ionenenergie vorzugsweise so gewählt, dass das Maximum des Implantationsprofils knapp unterhalb, d.h. typischerweise wenige 10 nm unter der Grenzfläche zwischen Substrat und der ionenstrahlsynthetisierten Schicht liegt.

Die Implantationsenergie kann jedoch auch so gewählt werden, dass das Implantationsmaximum innerhalb der ionenstrahlsynthetisierten Schicht liegt.

Ferner ist die Temperatur bei der Implantation so zu wählen, dass es zu keiner Amorphisierung der Halbleiterschichtstruktur kommt, also hauptsächlich nur Punktdefekte erzeugt werden. Im Falle von reinem Silizium ist also die Temperatur typischerweise oberhalb 130 °C zu wählen, so dass hier eine Ionenstrahl induzierte Amorphisierung nicht mehr auftritt.

Außerdem ist eine zu starke Ausdiffusion des implantierten Wasserstoffs bzw. Edelgases über die Temperatur einzuschränken, folglich sollte die Implantation bei einer Temperatur von kleiner oder gleich 800 °C stattfinden.

Die Implantationstemperaturen liegen vorzugsweise bei 130-800 °C, wobei Implantationstemperaturen von 250-500 °C besonders zu bevorzugen ist.

Über die Wahl der Implantationstemperatur lässt sich beeinflussen, ob Hohlräume bereits während der Implantation, oder erst in einem späteren thermischen Behandlungschritt gebildet werden. Um schmale Hohlraumverteilungen mit kleinen mittleren Hohlraumdurchmessern zu erzielen haben sich höhere Implantationstemperaturen (- 400 °C) als hilfreich erwiesen.

In einem nachfolgenden Ionenimplantationsschritt werden dann die Hohlräume vorzugsweise durch Implantation von leichten Gasionen, beispielsweise durch Implantation von Wasserstoff-, Helium-, Neon- oder Argonionen oder Kombinationen von Ionenimplantationen dieser Atomsorten gebildet, welche zur späteren Ausbildung von kompressiven Spannungen im Silicium sowie der Ausbildung von Versetzungen führen können.

Die Implantationsenergie wird vorzugsweise so gewählt, dass das Dichtemaximum an Hohlräumen innerhalb des Maximums des Implantationsprofils des Sauerstoff-, Kohlenstoff- oder Stickstoffimplantationsschrittes liegt.

Ein angeschlossener thermischer Behandlungsschritt führt zum einen zur Ausbildung größerer Hohlräume und gleichzeitig durch eine Verbindungsbildung der implantierten Sauerstoff-, Kohlenstoff- oder Stickstoffatomen mit dem Substrat, beispielsweise im Falle von Silicium zur Bildung von Si-O-, Si-C- oder Si-N-Bindungen, welche eine thermisch aktivierte diffusive Größenvergröberung der gebildeten Hohlräume stark erschwert.

Dadurch wird der Prozess der Ostwald-Reifung unterdrückt und somit der Dichteabnahme der Hohlräume entgegengewirkt.

Es resultiert also eine Halbleiterschichtstruktur mit einer hohen Dichte verhältnismäßig kleiner Hohlräume von wenigen Nanometern unterhalb der Grenzfläche zwischen ionenstrahlsynthetisierter Schicht und ursprünglichem Substrat. Weiterhin ist eine hohe Dichte anderer Defekte an dieser Stelle vorhanden, die die Ausbildung von interstitiellen Defektagglomeraten und Versetzungen begünstigt.

Wird dann auf diese Halbleiterschichtstruktur eine Schicht oder ein Schichtsystem aus einem Halbleitermaterial, das einen gegenüber dem Halbleitermaterial des Ausgangssubstrats (und somit der gesamten erzeugten Halbleiterschichtstruktur) stark unterschiedlichem thermischen Ausdehnungskoeffizienten aufweist, bei einer Temperatur von wenigstens 600°C abgeschieden, so bilden sich beim Abkühlen der Schichtstruktur in der defektreichen Zone zwischen den aufgrund der mittels Fremdatomen erreichten Stabilisierung noch zahlreich und dicht vorhandenen Hohlräumen Versetzungen und Stapelfehler aus.

Die abgeschiedene Halbleiterschichtstruktur relaxiert elastisch durch eine plastische Verformung in einem definierten Bereich - nämlich in dem Bereich, der die Hohlräume, sowie Defektstrukturen beinhaltet - des Substrats. Somit werden während des Abkühlvorgangs Spannungen im später abgeschiedenen Schichtsystem dynamisch abgebaut und ein Aufreißen der auf der Halbleiterschichtstruktur abgeschiedenen Schicht verhindert.

Durch diesen Prozess ist auch die Ausbildung von Fadenversetzungen ("threading dislocations") zur Schichtrelaxation in der abgeschiedenen Schicht bzw. Schichtstruktur verringert, da die nötige Anzahl der Versetzungen zur Relaxation stark herabgesetzt ist.

Eine mögliche Variation betrifft die Reihenfolge der Implantationsschritte zur Einbringung der Hohlraum stabilisierenden Fremdatome und zur Erzeugung der Hohlräume selbst bzw. zur Erzeugung deren Keime.

Da eine Stabilisierung der Hohlräume durch Verbindungsbildung mit den Fremdatomen erst später in einem Hochtemperaturbehandlungsschritt erfolgt, kann die Reihenfolge hier beliebig gewählt werden.

Bei einer weiteren alternativen Ausführung kann auf den separaten thermischen Behandlungsschritt nach der Erzeugung der thermisch stabilen Hohlraumstruktur verzichtet werden, wenn die Abscheidung einer weiteren Schicht bzw. Schichtstruktur bei einer Temperatur von wenigstens 600 °C erfolgt. In diesem Falle kann die Erzeugung und Passivierung der Hohlräume zusammen mit der Abscheidung der Schicht bzw. Schichtstruktur erfolgen.

Eine weitere Variation des Verfahrens betrifft die Bereitstellung der für die Stabilisierung der Hohlräume nötigen Fremdatome. Beinhaltet das Ausgangssubstrat bereits selbst derartige Fremdatome, ausgewählt aus einer Gruppe Sauerstoff, Kohlenstoff, Stickstoff oder Verbindungen dieser Elemente mit dem Substratmaterial, so wird vorzugsweise auf eine Implantation dieser Elemente verzichtet, wenn dieses Fremdatome in hoher Zahl hinter der Grenzfläche zwischen ionenstrahlsynthetisierter Schicht und Substrat vorliegen.

Dabei können die Fremdatome entweder im Substrat gelöst sein und/oder in Präzipitaten einer diese Fremdatome enthaltenden Verbindung vorliegen.

Ferner erlaubt das beschriebene Verfahren die Herstellung von Substraten für die großflächige Realisierung z.B. von III-V-Halbleitern, da es unabhängig von der Größe der Ausgangssubstrate und somit nur von der Verfügbarkeit dieser Substrate abhängig ist. Insbesondere seien hier gebräuchliche Siliciumscheiben-Durchmesser von 100 mm, 150 mm, 200 mm, 300 mm genannt, wobei sich die 450 mm-Scheiben derzeit in der Entwicklungsphase befinden.

Im Stand der Technik sind potentielle Substrate dagegen durch den Syntheseprozess auf Durchmesser von maximal 200 mm für Saphir, bzw. 100 mm für 6H- oder 4H-SiC beschränkt.

Besonders vorteilhaft sind auch die kurzen nötigen Prozesszeiten, da die für die Relaxation benötigten Implantationsdosen im Bereich von maximal wenigen 10¹⁷ cm⁻² liegen und der thermische Nachbehandlungsschritt entweder sehr kurz (im Sekundenbereich) wählbar ist oder - abhängig von der späteren Prozessierung - ganz entfallen kann.

Die erfindungsgemäßen Halbleiterschichtstrukturen eignen sich insbesondere zur Realisierung kostengünstiger Leuchtdioden (LEDs) speziell auf Basis von III-V-Halbleitern wie GaN oder InGaN, sowie für die Herstellung von Schottkydioden, Hochfrequenz- und Hochleistungsbauelementen, wie z.B. Transistoren mit hoher Elektronenbeweglichkeit (HEMTS), welche vor allem auf III-V-Halbleitern, wie AlN und GaN, sowie SiC basieren.

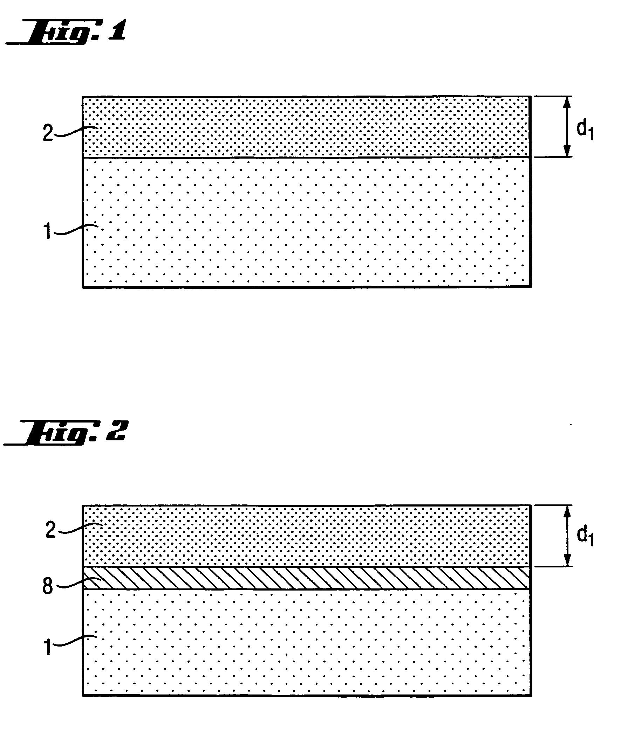

Nachfolgend soll der Gegenstand der Erfindung anhand von Beispielen und anhand von **Fig. 1-4** näher erläutert werden.

**Fig. 1** zeigt eine Halbleiterschichtstruktur, umfassend ein Substrat **1** und eine Schicht **2** der Dicke d1.

**Fig. 2** zeigt eine Halbleiterschichtstruktur, umfassend ein Substrat **1,** eine Schicht **2** der Dicke d₁ und einen Bereich **8** mit einer bestimmten Fremdatomdichte bzw. einer bestimmten fremdatomhaltigen Präzipitatdichte.

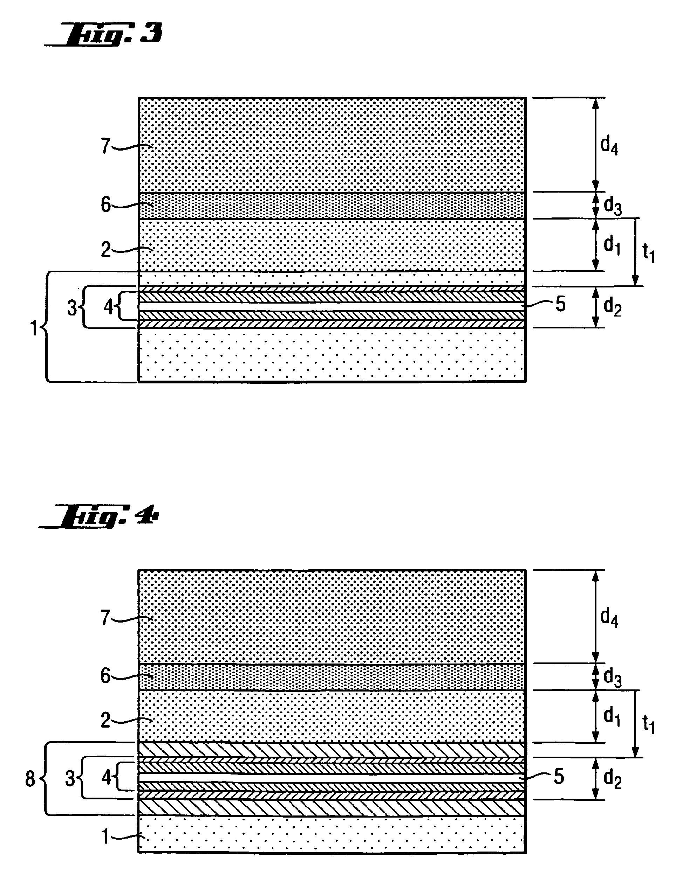

**Fig. 3** zeigt eine Halbleiterschichtstruktur, umfassend ein Substrat **1,** eine Schicht **2** der Dicke d₁, in einer Tiefe t₁ eine Fremdatom-implantierte Schicht **3** mit einer Dicke d₂, eine Schicht **4,** die Hohlräume bzw. Keime für Hohlräume beinhaltet, und weitere Schichten **6** der Dicke d₃ und **7** der Dicke d₄ mit gegenüber dem Substratmaterial stark unterschiedlichen thermischen Ausdehnungskoeffizienten, die zum Entstehen einer Schicht **5** führt, die Versetzungen und Stapelfehler beinhaltet.

**Fig. 4** zeigt eine Halbleiterschichtstruktur, umfassend ein Substrat **1,** eine Schicht **2** der Dicke d₁, einen Bereich **8** mit einer bestimmten Fremdatomdichte bzw. einer bestimmten fremdatomhaltigen Präzipitatdichte, in einer Tiefe t₁ eine jene Fremdatome beinhaltende Schicht **3** mit der Dicke d₂, eine Schicht **4,** die Hohlräume bzw. Keime für Hohlräume beinhaltet, und weitere Schichten **6** einer Dicke d₃ und **7** einer Dicke d₄ mit gegenüber dem Substratmaterial stark unterschiedlichen thermischen Ausdehnungskoeefizienten, und eine Schicht **5,** die Versetzungen beinhaltet.

Bei Substrat **1** in **Fig. 1** handelt es sich beispielsweise um monokristallines (111)-orientiertes Silicium.

Durch Hochdosis-Kohlenstoffionen-Implantation (Energie E = 180 keV, Dosis D = 6,75 x10 ¹⁷ cm⁻², Temperatur T = 550°C) wird eine vergrabene etwa 150 nm dicke Schicht **2** erzeugt, welche durch einen weitere amorphisierende Implantation von Heliumionen (50 keV, D = 8,0 x 10¹⁶ /cm² bei 0 °C) und mittels chemischem Ätzen in einer Lösung aus 1:5 HF:HNO₃ freigelegt wird. Dadurch entsteht eine etwa 70 nm dicke ionenstrahlsynthetisierte 3C-SiC-Schicht **2,** welche an der Oberfläche des Substrats **1** liegt.

Nachfolgend werden bei einer Temperatur von 400 °C He⁺-Ionen mit einer Energie von 22 keV und einer Dosis von 2 x 10¹⁶ /cm² in den Bereich **3** implantiert, welcher bis jetzt noch keine Fremdatome enthält.

Direkt im Anschluss erfolgt dann ebenfalls bei einer Temperatur von 400 °C eine Implantation von 5 x 10¹⁴ /cm² O⁺-Ionen bei einer Energie von 85 keV in den Bereich **3,** der sich wenige nm bis zu einigen 10 nm unterhalb der Grenzfläche zwischen ionenstrahlsynthetisierter Schicht **2** und Substrat **1** befindet.

Dadurch bildet sich in einem definierten Tiefenbereich eine Schicht **4** mit Hohlräumen bzw. Keimen für das spätere Wachstum von Hohlräumen, wobei das Dichtemaximum an Hohlräumen mit dem Maximum der Sauerstoffkonzentration ungefähr zusammenfällt.

Auf diese Halbleiterschichtstruktur wird dann mittels MOCVD bei einer Temperatur von 1100 °C zunächst eine 150 nm dicke Schicht **6** aus Aluminiumnitrid (AlN) abgeschieden.

Nach Absenkung der Temperatur auf 1080 °C wird aus den Prekursoren Tetraethylgallium und Ammoniak eine 3 µm dicke Schicht **7** aus Galliumnitrid (GaN) aufgewachsen. Die Wachstumsrate liegt bei etwa 1 µm/h, so dass der gesamte Prozess etwa 3 h dauert.

Nach Abkühlen der Schicht ist die abgeschiedene Schicht weitgehend spannungsfrei und zeigt insbesondere keine Risse. Dies resultiert aus der Bildung einer Defektstruktur aus Hohlräumen **4** und Versetzungen **5,** die dynamisch die Spannungen in der Schichtstruktur abbaut, da jene Defektstruktur eine plastische Relaxation zwischen Substrat **1** und den nitridhaltigen Schichten **6** und **7** erlaubt. Dies geschieht, ohne dass es zu einem lateralen Durchreißen des Substrats im Bereich der erzeugten Hohlräume kommt. Die resultierende Halbleiterschichtstruktur ist in **Fig. 3** gezeigt.

Eine Variation dieses Verfahrens ist die Verwendung einer Halbleiterschichtstruktur mit einer fremdatomhaltigen Schicht **8,** wie in **Fig. 2** dargestellt. Dabei kann die Sauerstoffimplantation entfallen. Es werden lediglich Hohlräume durch Heliumimplantation erzeugt, welche dann bevorzugt an den Ausscheidungen gebildet werden. Diese energetisch günstige Konfiguration ist ebenfalls weitgehend temperaturstabil.

Anschließend wird wiederum eine 150 nm dicke Schicht **6** aus AlN, sowie nachfolgend eine 3 µm dicke Schicht **7** aus GaN mittels MOCVD aufgewachsen. Beim Abkühlen bildet sich dann wieder eine Defektstruktur aus Hohlräumen und Versetzungen aus und fängt dynamisch die durch die unterschiedlichen thermischen Ausdehnungskoeffizienten bedingten Schichtspannungen ab. Die resultierende Schichtstruktur ist in **Fig. 4** dargestellt.

Alternativ dazu kann in obigen Beispiel die Immobilisierung der Hohlräume dadurch optimiert werden, dass in einem thermischen Behandlungsschritt vor der MOCVD-Abscheidung die Oberflächen der Hohlräume ideal mit Fremdatombindungen - in diesem Falle Si-O-Bindungen - belegt werden. Die Notwendigkeit eines solchen Prozessschrittes ist abhängig von der Prozessdauer und - temperatur der MOCVD-Abscheidung, da diese Parameter die Kinetik der Ostwaldreifung der Hohlräume bzw. gasgefüllten Blasen bestimmen. Insbesondere ist ein solcher Prozessschritt besonders bei langen Abscheidungen (>2h) bei hohen Temperaturen (>1000 °C) zu bevorzugen. Vor allem kann man hier die Temperbedingungen so wählen, dass sich ausreichend viele stabilisierende Bindungen ausbilden, eine Ostwald-Reifung der Hohlräume jedoch weitgehend unterbleibt.

Eine weitere Variation betrifft z.B. die Verwendung von oben geschilderten 3C-SiC-Schichtsystemen. In diesem Fall liegen im Substrat **1** unterhalb der ionenstrahlsynthetisierten Schicht **2** in einem Tiefenbereich von typischerweise 0 nm bis 200 nm unterhalb der Grenzfläche zahlreiche 3C-SiC-Präzipitate vor. Dieser Bereich besteht also aus einer Siliziummatrix mit einer hohen Dichte an weitgehend fehlorientierten 3C-SiC-Ausscheidungen.

Bei der Bildung von Hohlräumen mittels Heliumimplantation und anschließender Hochtemperaturbehandlung zeigt sich, dass sich die Hohlräume überwiegend an diese Präzipitate anlagern und auch hierdurch thermisch immobilisiert werden. Dafür verantwortlich ist zum einen die Möglichkeit durch eine gemeinsame Grenzfläche die Gesamtgrenzflächenenergie zum Siliciumsubstrat zu erniedrigen und zum anderen die Ausbildung von Si-C-Bindungen an der Hohlraumoberfläche. Es hat sich allerdings gezeigt, dass der Immobilisierungseffekt durch eine weitere Implantation von Sauerstoff weiter verstärkt werden kann, so dass eine noch stärkere Relaxation erreicht werden kann. Die Notwendigkeit eines solchen Implantationsschrittes ergibt sich also jeweils aus dem, für die jeweilige Anwendung gewünschten, Relaxationsgrad der abgeschiedenen Schicht.

## Patentansprüche

1. Verfahren zur Herstellung einer Halbleiterschichtstruktur, umfassend folgende Schritte: a) Bereitstellen eines Substrats (1) aus Halbleitermaterial; b) Aufbringen einer Schicht (2) aus einem zweiten Halbleitermaterial auf dieses Substrat (1) zur Erzeugung einer Halbleiterschichtstruktur; c) Implantation von Gasionen einer oder mehrerer Atomsorten, ausgewählt aus einer Gruppe bestehend aus Wasserstoff und Edelgasen, in die Halbleiterschichtstruktur zur Erzeugung einer Hohlräume beinhaltenden Schicht (4) in der Halbleiterschichtstruktur; d) Aufbringen von wenigstens einer epitaktischen Schicht (6) auf die Halbleiterschichtstruktur, **dadurch gekennzeichnet, dass** es sich bei dem Substrat (1) um ein Siliciumsubstrat oder um ein Substrat, das eine Siliciumschicht beinhaltet, und bei der Schicht (2) um Siliciumcarbid handelt, dass durch Implantation von Kohlenstoffionen in das Substrat (1) eine vergrabene Siliciumcarbid-Schicht und durch deren anschließendes Freilegen die Schicht (2) erzeugt wird und dass Fremdatome einer oder mehrerer Atomsorten, ausgewählt aus der Gruppe Sauerstoff, Stickstoff und Kohlenstoff, mit einer Dosis von höchstens 5x10¹⁷ cm⁻² in die Halbleiterschichtstruktur implantiert werden, um die durch Gasimplantation erzeugten Hohlräume in der Hohlräume beinhaltenden Schicht (4) thermisch zu stabilisieren.

2. Verfahren nach Anspruch 1, **dadurch gekennzeichnet, dass** es sich bei dem in a) bereitgestellten Substrat (1) um eine Scheibe aus monokristallinem Silicium handelt.

3. Verfahren nach Anspruch 1, **dadurch gekennzeichnet, dass** es sich bei dem in a) bereitgestellten Substrat (1) um eine SOI-Scheibe handelt.

4. Verfahren nach einem der Ansprüche 1 bis 3, **dadurch gekennzeichnet, dass** es sich bei der in b) aufgebrachten Schicht (2) um eine Schichtstruktur handelt, die einen Bereich hoher SiC-Präzipitatdichte und eine monokristalline Siliciumcarbidschicht beinhaltet.

5. Verfahren nach einem der Ansprüche 1 bis 4, **dadurch gekennzeichnet, dass** die wenigstens eine in d) aufgebrachte epitaktische Schicht (6) Halbleitermaterial mit einem gegenüber dem Halbleitermaterial von Substrat (1) deutlich verschiedenen thermischen Ausdehnungskoeffizienten beinhaltet.

6. Verfahren nach Anspruch 5, **dadurch gekennzeichnet, dass** die wenigstens eine in d) aufgebrachte epitaktische Schicht (6) einen Nitridverbindungshalbleiter beinhaltet.

7. Verfahren nach einem der Ansprüche 1 bis 6, **dadurch gekennzeichnet, dass** bei der Implantation von Gasionen in Schritt c) die Edelgasionen ausgewählt werden aus der Gruppe Helium, Neon und Argon.

8. Verfahren nach einem der Ansprüche 1 bis 7, **dadurch gekennzeichnet, dass** bei der Implantation von Gasionen in Schritt c) die Implantationsenergie so gewählt wird, dass sich die in der Halbleiterschichtstruktur erzeugte, Hohlräume beinhaltende Schicht (4) unterhalb einer Grenzfläche zwischen aufgebrachter Schicht (2) und Substrat (1) befindet.

9. Verfahren nach einem der Ansprüche 1 bis 8, **dadurch gekennzeichnet, dass** bei der Implantation von Gasionen in Schritt c) die Implantationsenergie so gewählt wird, dass sich die in der Halbleiterschichtstruktur erzeugte, Hohlräume beinhaltende Schicht (4) innerhalb der aufgebrachten Schicht (2) befindet.

10. Verfahren nach einem der Ansprüche 1 bis 9, **dadurch gekennzeichnet, dass** vor der Implantation von Fremdatomen einer oder mehrerer Atomsorten, ausgewählt aus der Gruppe Sauerstoff, Stickstoff und Kohlenstoff, eine thermische Behandlung der Halbleiterschichtstruktur bei einer Temperatur von wenigstens 600°C erfolgt.

11. Verfahren nach einem der Ansprüche 1 bis 10, **dadurch gekennzeichnet, dass** Kohlenstoffionen in eine bestimmte Tiefe des Substrats (1), bei dem es sich um eine Siliciumscheibe handelt, implantiert werden, dieses dann thermisch behandelt wird, wodurch sich im Substrat (1) eine vergrabene monokristalline Siliciumcarbid-Schicht (2) sowie oberhalb und unterhalb der monokristallinen Schicht Übergangsregionen ausbilden, nachfolgend die obere Substratschicht sowie die über der monokristallinen Schicht (2) liegende Übergangsregion abgetragen werden, wodurch die monokristalline Siliciumcarbid-Schicht (2) freigelegt wird.

12. Halbleiterschichtstruktur, umfassend ein Substrat (1) aus Silicium oder ein eine Siliciumschicht beinhaltendes Substrat (1), auf dem sich eine Schicht (2) aus Siliciumcarbid befindet, des Weiteren einen mit Fremdatomen einer oder mehrerer Atomsorten, ausgewählt aus der Gruppe bestehend aus Sauerstoff, Stickstoff und Kohlenstoff, angereicherten Bereich (3), der sich entweder in der Schicht (2) oder in einer bestimmten Tiefe unterhalb der Grenzfläche zwischen der Schicht (2) und dem Substrat (1) befindet und Siliciumcarbidpräzipitate beinhaltet, außendem eine Schicht (4) innerhalb des mit Fremdatomen angereicherten Bereichs (3), die Hohlräume in Form von Wasserstoff- und/oder Edelgasbläschen beinhaltet, des Weiteren wenigstens eine epitaktische Schicht (6), die auf der Schicht (2) aufgebracht ist, sowie einen Defektbereich (5) aus Versetzungen und Stapelfehlern innerhalb der Hohlräume beinhaltenden Schicht (4), wobei die wenigstens eine epitaktische Schicht (6) weitgehend rissfrei ist, und eine residuale Verspannung der wenigstens einen epitaktischen Schicht (6) kleiner oder gleich 1 GPa beträgt.

13. Halbleiterschichtstruktur nach Anspruch 12, wobei die residuale Verspannung der wenigstens einen epitaktischen Schicht (6) kleiner oder gleich 370 MPa beträgt.

14. Halbleiterschichtstruktur nach einem der Ansprüche 12 oder 13, wobei die Rauhigkeit der wenigstens einen epitaktischen Schicht (6) 0,5-7,0 nm RMS beträgt.

15. Halbleiterschichtstruktur nach Anspruch 14, wobei die Rauhigkeit der wenigstens einen epitaktischen Schicht (6) 0,5-2,0 mm RMS beträgt.

16. Halbleiterschichtstruktur nach einem der Ansprüche 12 bis 15, **dadurch gekennzeichnet, dass** es sich bei dem Substrat (1) um eine Scheibe aus monokristallinem Silicium handelt.

17. Halbleiterschichtstruktur nach einem der Ansprüche 12 bis 15, **dadurch gekennzeichnet, dass** es sich bei dem Substrat (1) um eine SOI-Scheibe handelt.

18. Halbleiterschichtstruktur nach einem der Ansprüche 12 bis 17, **dadurch gekennzeichnet, dass** es sich bei der Schicht (2) um eine Schichtstruktur handelt, die einen Bereich hoher SiC-Präzipitatdichte und eine monokristalline Siliciumcarbid-Schicht beinhaltet.

19. Halbleiterschichtstruktur nach einem der Ansprüche 12 bis 18, **dadurch gekennzeichnet, dass** die wenigstens eine epitaktische Schicht (6) Halbleitermaterial mit einem gegenüber dem Halbleitermaterial des Substrats (1) deutlich verschiedenen thermischen Ausdehnungskoeffizienten beinhaltet.

20. Halbleiterschichtstruktur nach Anspruch 19, **dadurch gekennzeichnet, dass** die wenigstens eine epitaktische Schicht (6) einen Nitridverbindungshalbleiter beinhaltet.

21. Halbleiterschichtstruktur nach Anspruch 20, **dadurch gekennzeichnet, dass** auf die Halbleiterschichtstruktur eine weitere epitaktische Schicht (7) aufgebracht ist, die einen Nitridverbindungshalbleiter beinhaltet.

22. Halbleiterschichtstruktur nach Anspruch 21, **dadurch gekennzeichnet, dass** die epitaktische Schicht (6) Aluminiumnitrid beinhaltet.

23. Halbleiterschichtstruktur nach Anspruch 22, **dadurch gekennzeichnet, dass** die weitere epitaktische Schicht (7) Galliumnitrid beinhaltet.

24. Halbleiterschichtstruktur nach einem der Ansprüche 12 bis 23, wobei eine mittels hochauflösender Röntgenbeugung gemessene relative Ausdehnung der Gitterkonstante von Siliciumcarbid der Schicht (2) kleiner oder gleich 0,2% beträgt.

25. Halbleiterschichtstruktur nach Anspruch 24, wobei das Substrat (1) einen Durchmesser von größer oder gleich 100 mm aufweist.

26. Halbleiterschichtstruktur nach Anspruch 24, wobei die Schicht (2) aus Siliciumcarbid sich unterhalb einer Oberfläche von Substrat (1) befindet.

27. Halbleiterschichtstruktur nach einem der Ansprüche 12 bis 26, die einen Versetzungen beinhaltenden Defektbereich (5) in oder unterhalb der Schicht (2) umfasst.

28. Halbleiterschichtstruktur nach Anspruch 27, wobei die Hohlräume beinhaltende Schicht (4) gegenüber thermischer Spaltung bei Temperaturen von 25-1250°C resistent ist.

29. Halbleiterschichtstruktur nach einem der Ansprüche 20 bis 23, weiterhin umfassend eine oder mehrere epitaktische Zwischenschichten, die sich zwischen der Schicht (2) und der wenigstens einen, einen Nitridverbindungshalbleiter beinhaltenden epitaktischen Schicht (6) befinden.

30. Halbleiterbauelement, auf einer Halbleiterschichtstruktur nach einem der Ansprüche 20 bis 29, welches Licht einer Energie von größer oder gleich 0,1 eV und kleiner oder gleich 7 eV emittiert.

## Claims

1. Method for fabricating a semiconductor layer structure, comprising the following steps: a) provision of a substrate (1) made of a semiconductor material; b) application of a layer (2) made of a second semiconductor material to said substrate (1) for the purpose of producing a semiconductor layer structure; c) implantation of gas ions of one or more atom types, selected from a group consisting of hydrogen and noble gases, into the semiconductor layer structure for the purpose of producing a layer (4) comprising cavities in the semiconductor layer structure; d) application of at least one epitaxial layer (6) to the semiconductor layer structure, **characterized in that** the substrate (1) is a silicon substrate or a substrate which comprises a silicon layer, and the layer (2) is silicon carbide, **in that**, by implantation of carbon ions into the substrate (1), a buried silicon carbide layer is produced and by the subsequent uncovering thereof the layer (2) is produced, and **in that** impurity atoms of one or more atom types, selected from the group of oxygen, nitrogen and carbon, are implanted into the semiconductor layer structure with a dose of at most 5×10¹⁷ cm⁻², in order to thermally stabilize the cavities produced by gas implantation in the layer (4) comprising cavities.

2. Method according to Claim 1, **characterized in that** the substrate (1) provided in a) is a wafer made of monocrystalline silicon.

3. Method according to Claim 1, **characterized in that** the substrate (1) provided in a) is an SOI wafer.

4. Method according to one of Claims 1 to 3, **characterized in that** the layer (2) applied in b) is a layer structure comprising a region of high SiC precipitate density and a monocrystalline silicon carbide layer.

5. Method according to one of Claims 1 to 4, **characterized in that** the at least one epitaxial layer (6) applied in d) comprises semiconductor material having a significantly different coefficient of thermal expansion in comparison with the semiconductor material of substrate (1).

6. Method according to Claim 5, **characterized in that** the at least one epitaxial layer (6) applied in d) comprises a nitride compound semiconductor.

7. Method according to one of Claims 1 to 6, **characterized in that**, in the implantation of gas ions in step c), the noble gas ions are selected from the group of helium, neon and argon.

8. Method according to one of Claims 1 to 7, **characterized in that**, in the implantation of gas ions in step c), the implantation energy is chosen such that the layer (4) comprising cavities which is produced in the semiconductor layer structure is situated below an interface between applied layer (2) and substrate (1).

9. Method according to one of Claims 1 to 8, **characterized in that**, in the implantation of gas ions in step c), the implantation energy is chosen such that the layer (4) comprising cavities which is produced in the semiconductor layer structure is situated within the applied layer (2).

10. Method according to one of Claims 1 to 9, **characterized in that**, prior to the implantation of impurity atoms of one or more atom types, selected from the group of oxygen, nitrogen and carbon, a thermal treatment of the semiconductor layer structure at a temperature of at least 600°C is effected.

11. Method according to one of Claims 1 to 10, **characterized in that** carbon ions are implanted into a specific depth of the substrate (1), which is a silicon wafer, the substrate is then treated thermally, as a result of which in the substrate (1) a buried monocrystalline silicon carbide layer (2) and also, above and below the monocrystalline layer, transition regions form and the upper substrate layer and also the transition region lying above the monocrystalline layer (2) are subsequently removed, as a result of which the monocrystalline silicon carbide layer (2) is uncovered.

12. Semiconductor layer structure, comprising a substrate (1) made of silicon or a substrate (1) comprising a silicon layer, on which a layer (2) made of silicon carbide is situated, furthermore a region (3) enriched with impurity atoms of one or more atom types, selected from the group consisting of oxygen, nitrogen and carbon, which region is situated either in the layer (2) or at a specific depth below the interface between the layer (2) and the substrate (1) and comprises silicon carbide precipitates, additionally a layer (4) within the region (3) enriched with impurity atoms, which layer comprises cavities in the form of hydrogen and/or noble gas bubbles, furthermore at least one epitaxial layer (6) applied to the layer (2) and also a defect region (5) comprising dislocations and stacking faults within the layer (4) comprising cavities, the at least one epitaxial layer (6) being largely crack-free, and a residual strain of the at least one epitaxial layer (6) being less than or equal to 1 GPa.

13. Semiconductor layer structure according to Claim 12, the residual strain of the at least one epitaxial layer (6) being less than or equal to 370 MPa.

14. Semiconductor layer structure according to either of Claims 12 and 13, the roughness of the at least one epitaxial layer (6) being 0.5-7.0 nm RMS.

15. Semiconductor layer structure according to Claim 14, the roughness of the at least one epitaxial layer (6) being 0.5-2.0 nm RMS.

16. Semiconductor layer structure according to one of Claims 12 to 15, **characterized in that** the substrate (1) is a wafer made of monocrystalline silicon.

17. Semiconductor layer structure according to one of Claims 12 to 15, **characterized in that** the substrate (1) is an SOI wafer.

18. Semiconductor layer structure according to one of Claims 12 to 17, **characterized in that** the layer (2) is a layer structure comprising a region of high SiC precipitate density and a monocrystalline silicon carbide layer.

19. Semiconductor layer structure according to one of Claims 12 to 18, **characterized in that** the at least one epitaxial layer (6) comprises semiconductor material having a significantly different coefficient of thermal expansion in comparison with the semiconductor material of the substrate (1).

20. Semiconductor layer structure according to Claim 19, **characterized in that** the at least one epitaxial layer (6) comprises a nitride compound semiconductor.

21. Semiconductor layer structure according to Claim 20, **characterized in that** a further epitaxial layer (7) comprising a nitride compound semiconductor is applied to the semiconductor layer structure.

22. Semiconductor layer structure according to Claim 21, **characterized in that** the epitaxial layer (6) comprises aluminium nitride.

23. Semiconductor layer structure according to Claim 22, **characterized in that** the further epitaxial layer (7) comprises gallium nitride.

24. Semiconductor layer structure according to one of Claims 12 to 23, a relative expansion of the lattice constant of silicon carbide of the layer (2) as measured by means of high-resolution X-ray diffraction being less than or equal to 0.2%.

25. Semiconductor layer structure according to Claim 24, the substrate (1) having a diameter of greater than or equal to 100 mm.

26. Semiconductor layer structure according to Claim 24, the layer (2) made of silicon carbide being situated below a surface of substrate (1).

27. Semiconductor layer structure according to one of Claims 12 to 26, which comprises a defect region (5) comprising dislocations in or below the layer (2).

28. Semiconductor layer structure according to Claim 27, the layer (4) comprising cavities being resistant to thermal cleavage at temperatures of 25-1250°C.

29. Semiconductor layer structure according to one of Claims 20 to 23, furthermore comprising one or more epitaxial interlayers situated between the layer (2) and the at least one epitaxial layer (6) comprising a nitride compound semiconductor.

30. Semiconductor component, on a semiconductor layer structure according to one of Claims 20 to 29 which emits light having an energy of greater than or equal to 0.1 eV and less than or equal to 7 eV.

## Revendications

1. Procédé de fabrication d'une structure semi-conductrice stratifiée, comprenant les étapes suivantes :
a) préparation d'un substrat (1) en un matériau semi-conducteur,
b) application d'une couche (2) d'un deuxième matériau semi-conducteur sur ce substrat (1) pour former une structure semi-conductrice stratifiée,
c) implantation d'ions de gaz d'une ou de plusieurs sortes d'atomes sélectionnés dans l'ensemble constitué de l'hydrogène et des gaz rares dans la structure semi-conductrice stratifiée pour former dans la structure semi-conductrice stratifiée une couche (4) qui contient des cavités,
d) application d'au moins une couche d'épitaxie (6) sur la structure semi-conductrice stratifiée,
**caractérisé en ce que**
le substrat (1) est un substrat de silicium ou un substrat qui contient une couche de silicium, la couche (2) étant en carbure de silicium,
**en ce qu'**une couche enfouie de carbure de silicium est formée par implantation d'ions de carbone dans le substrat (1), la couche (2) étant formée ensuite en la libérant, et
**en ce que** des atomes étrangers d'une ou plusieurs sortes d'atomes sélectionnés dans l'ensemble constitué de l'oxygène, de l'azote et du carbone sont implantés dans la structure semi-conductrice stratifiée à une dose d'au plus 5 x 10¹⁷ cm⁻² pour stabiliser thermiquement les cavités formées par implantation de gaz dans la couche (4) qui contient les cavités.

2. Procédé selon la revendication 1, **caractérisé en ce que** le substrat (1) préparé en a) est une plaque de silicium monocristallin.

3. Procédé selon la revendication 1, **caractérisé en ce que** le substrat (1) préparé en a) est une plaque de SOI.

4. Procédé selon l'une des revendications 1 à 3, **caractérisé en ce que** la couche (2) appliquée en b) est une structure stratifiée qui contient une partie à haute densité de SiC précipité et une couche de carbure de silicium monocristallin.

5. Procédé selon l'une des revendications 1 à 4, **caractérisé en ce que** la ou les couches d'épitaxie (6) appliquées en d) contiennent un matériau semi-conducteur dont le coefficient de dilatation thermique est nettement différent de celui du matériau semi-conducteur du substrat (1).

6. Procédé selon la revendication 5, **caractérisé en ce que** la ou les couches d'épitaxie (6) appliquées en d) contient un semi-conducteur à composés de nitrure.

7. Procédé selon l'une des revendications 1 à 6, **caractérisé en ce que** lors de l'implantation d'ions de gaz à l'étape c), les ions de gaz rares sont sélectionnés dans l'ensemble constitué de l'hélium, du néon et de l'argon.

8. Procédé selon l'une des revendications 1 à 7,
**caractérisé en ce que** lors de l'implantation d'ions de gaz à l'étape c), l'énergie d'implantation est sélectionnée de telle sorte que la couche (4) qui contient des cavités et formée dans la structure semi-conductrice stratifiée est située en dessous d'une surface frontière entre la couche (2) appliquée et le substrat (1).

9. Procédé selon l'une des revendications 1 à 8, **caractérisé en ce que** lors de l'implantation d'ions de gaz à l'étape c), l'énergie d'implantation est sélectionnée de telle sorte que la couche (4) qui contient des cavités et qui est formée dans la structure semi-conductrice stratifiée est située à l'intérieur de la couche (2) appliquée.

10. Procédé selon l'une des revendications 1 à 9, **caractérisé en ce qu'**avant l'implantation d'atomes étrangers d'une ou de plusieurs sortes d'atomes sélectionnés dans l'ensemble constitué de l'oxygène, de l'azote et du carbone, un traitement thermique de la structure semi-conductrice stratifiée est réalisé à une température d'au moins 600 °C.

11. Procédé selon l'une des revendications 1 à 10, **caractérisé en ce que** les ions de carbone sont implantés à une profondeur définie du substrat (1) qui est une plaque de silicium, le substrat étant ensuite traité thermiquement pour former dans le substrat (1) une couche monocristalline enfouie (2) de carbure de silicium ainsi que des régions de transition au-dessus et en dessous de la couche monocristalline, la couche supérieure du substrat ainsi que la région de transition située au-dessus de la couche monocristalline (2) étant ensuite enlevées pour libérer la couche monocristalline (2) de carbure de silicium.

12. Structure semi-conductrice stratifiée comprenant :
un substrat (1) en silicium ou un substrat (1) qui contient une couche de silicium et sur lequel est située une couche (2) en carbure de silicium,
ainsi qu'une partie (3) enrichie en atomes étrangers d'une ou plusieurs sortes d'atomes sélectionnés dans l'ensemble constitué de l'oxygène, de l'azote et du carbone, qui est située dans la couche (2) ou à une profondeur définie en dessous de la surface frontière entre la couche (2) et le substrat (1) et qui contient des précipités de carbure de silicium,
avec en outre une couche (4) située à l'intérieur de la partie (3) enrichie en atomes étrangers et contenant les cavités sous la forme de bulles d'hydrogène et/ou de gaz rares,
ainsi qu'au moins une couche d'épitaxie (6) appliquée en outre sur la couche (2) et une zone de défauts (5) constituée de dislocations et de défauts empilés à l'intérieur de la couche (4) qui contient des cavités,
la ou les couches d'épitaxie (6) étant largement exemptes de fissures et une contrainte résiduelle de la ou des couches d'épitaxie (6) étant inférieure ou égale à 1 GPa.

13. Structure semi-conductrice stratifiée selon la revendication 12, dans laquelle la contrainte résiduelle de la ou des couches d'épitaxie (6) sont inférieures ou égales à 370 MPa.

14. Structure semi-conductrice stratifiée selon l'une des revendications 12 ou 13, dans laquelle la rugosité de la ou des couches d'épitaxie (6) est comprise entre 0,5 et 7,0 nm RMS.

15. Structure semi-conductrice stratifiée selon la revendication 14, dans laquelle la rugosité de la ou des couches d'épitaxie (6) est comprise entre 0,5 et 2,0 nm RMS.

16. Structure semi-conductrice stratifiée selon l'une des revendications 12 à 15, **caractérisée en ce que** le substrat (1) est une plaque de silicium monocristallin.

17. Structure semi-conductrice stratifiée selon l'une des revendications 12 à 15, **caractérisée en ce que** le substrat (1) est une plaque de SOI.

18. Structure semi-conductrice stratifiée selon l'une des revendications 12 à 17, **caractérisée en ce que** la couche (2) est une structure stratifiée qui contient une partie à haute densité de SiC précipité et une couche monocristalline de carbure de silicium.

19. Structure semi-conductrice stratifiée selon l'une des revendications 12 à 18, **caractérisée en ce que** la ou les couches d'épitaxie (6) contiennent un matériau semi-conducteur dont le coefficient de dilatation thermique est nettement différent de celui du matériau semi-conducteur du substrat (1).

20. Structure semi-conductrice stratifiée selon la revendication 19, **caractérisée en ce que** la ou les couches d'épitaxie (6) contiennent un semi-conducteur à composés de nitrure.

21. Structure semi-conductrice stratifiée selon la revendication 20, **caractérisée en ce qu'**une autre couche d'épitaxie (7) qui contient un semi-conducteur à composés de nitrure est appliquée sur la structure semi-conductrice stratifiée.

22. Structure semi-conductrice stratifiée selon la revendication 21, **caractérisée en ce que** la couche d'épitaxie (6) contient du nitrure d'aluminium.

23. Structure semi-conductrice stratifiée selon la revendication 22, **caractérisée en ce que** l'autre couche d'épitaxie (7) contient du nitrure de gallium.

24. Structure semi-conductrice stratifiée selon l'une des revendications 12 à 23, dans laquelle une dilatation relative, mesurée par diffraction de rayons X à haute résolution, de la constante de grille du carbure de silicium de la couche (2) est inférieure ou égale à 0,2 %.

25. Structure semi-conductrice stratifiée selon la revendication 24, dans laquelle le substrat (1) a un diamètre supérieur ou égal à 100 mm.

26. Structure semi-conductrice stratifiée selon la revendication 24, dans laquelle la couche (2) en carbure de silicium est située en dessous d'une surface du substrat (1).

27. Structure semi-conductrice stratifiée selon l'une des revendications 12 à 26, qui comprend une zone de défauts (5) contenant des dislocations dans la couche (2) ou en dessous de celle-ci.

28. Structure semi-conductrice stratifiée selon la revendication 27, dans laquelle la couche (4) qui contient des cavités résiste à une dissociation thermique à des températures de 25 à 1 250°C.

29. Structure semi-conductrice stratifiée selon l'une des revendications 20 à 23, qui comprend en outre une ou plusieurs couches intermédiaires d'épitaxie qui sont situées entre la couche (2) et la ou les couches d'épitaxie (6) qui contiennent un semi-conducteur à composés de nitrure.

30. Composant semi-conducteur sur une structure semi-conductrice stratifiée selon l'une des revendications 20 à 29, qui émet de la lumière dont l'énergie est supérieure ou égale à 0,1 eV et inférieure ou égale à 7 eV.
